**Europäisches Patentamt**

**European Patent Office**

**Office européen des brevets**

(19)

(11) Publication number: **0 174 391**
**B1**

(12)

# EUROPEAN PATENT SPECIFICATION

(45) Date of publication of patent specification: **07.12.88**

(51) Int. Cl.⁴: **C 30 B 15/30**

(21) Application number: **84111306.1**

(22) Date of filing: **21.09.84**

(54) Baffle plate moving device.

(30) Priority: **31.08.84 JP 182438/84**

(43) Date of publication of application:
**19.03.86 Bulletin 86/12**

(45) Publication of the grant of the patent:
**07.12.88 Bulletin 88/49**

(84) Designated Contracting States:
**DE FR GB IT**

(56) References cited:
**DE-A-2 306 754**
**DE-A-2 517 849**
**JP-A-57 179 099**
**JP-A-57 200 286**
**JP-A-58 091 098**
**JP-A-58 194 793**

**PATENTS ABSTRACTS OF JAPAN, vol. 8, no. 19, January 26, 1984, (C-207) 1456r; & JP - A - 58 185 493 (HITACHI SEISAKUSHO K.K.) 29-10-1983**

**PATENTS ABSTRACTS OF JAPAN, vol. 8, no. 30 (C-209) 1467r, February 8, 1984; & JP - A - 58 194 793 (NIPPON DENKI K.K.) 12-11-1983**

(73) Proprietor: **GAKEI ELECTRIC WORKS CO., LTD.**
**18-9, Senjyu-sakuragi 2-chome Adachi-ku**
**Tokyo (JP)**

(72) Inventor: **Nishizawa, Minoru**
**33-3, Senjyu-motomachi Adachi-ku**
**Tokyo (JP)**

(74) Representative: **Patentanwälte Viering & Jentschura**
**Steinsdorfstrasse 6**
**D-8000 München 22 (DE)**

EP 0 174 391 B1

Courier Press, Leamington Spa, England.

**Description**

The present invention relates to an apparatus for pulling a single crystal, comprising a device for moving a baffle plate which is floated in the interior of a crucible in pulling-up the single crystal.

In growing a single crystal of silicon (Si) or a compound semiconductor of Groups III—V, especially gallium arsenide (GaAs) or gallium phosphide (GaP), from a feed melt contained in a crucible, there has been known the technique of floating a heat convection preventing baffle plate in the feed melt for preventing a natural heat convection occurring which causes a heat distortion.

It has been proposed to float a baffle plate in a predetermined position below the surface of a feed melt by virtue of its buoyancy, but in this case the floating position is unstable, and as the level of the feed melt lowers with pulling-up of a single crystal, it becomes difficult to hold the baffle plate in the predetermined position.

It has also been proposed to fix a single moving rod to a baffle plate to move the baffle plate with lowering of the liquid level (Patent Abstracts of Japan, Vol. 8, n° 1S, January 26, 1984, C-207, 1456). In this case, however, for pulling up a single crystal, since the fixing position must be spaced from the center of the baffle plate the baffle plate may be bent or inclined in use, and thus a very unstable condition results.

On the other hand, in pulling-up single crystals of compound semiconductors of Groups III—V typified by GaAs and GaP melting as high as 1238°C and 1470°C and exhibiting dissociation pressures as high as about 1 atm and 30 atm, respectively, there has been developed a technique in which the upper surface of a feed melt is covered with a liquid sealing agent such as $B_2O_3$, and the interior of a furnace is place under an inert gas atmosphere of an extremely high pressure of ten-odd to one hundred and several ten atm. In this case, if the drive force transmitting means for a baffle plate moving rod is sealed against the furnace by a conventional sealing means using a mere sealing material, the sealing material will expand due to the high pressure in the furnace, thus making it impossible to effect a smooth transmission of the drive force and to maintain the furnace interior gas-tight completely.

Besides, in the case where plural moving rods are used, the baffle plate will be inclined or bent unless all the moving rods are moved up and down at the same rate. Thus, the problem is how efficiently the moving rod driving mechansim is to be mounted in a limited space so as not to obstruct other devices.

Further, in the case of utilizing a single crystal pulling-up shaft as the drive source, the growth of crystal is badly influenced by vibrations which occur during transmission of the drive force.

It is a primary object of the present invention to provide a baffle plate moving device whereby a baffle plate floated in a feed melt can be held in a predetermined position always in a stable state without being inclined or bent even as the melt level becomes lowered during pulling of and growth of a single crystal.

It is a secondary object of the present invention to provide a baffle plate moving device whereby, in the case where the interior of a furnace is in an inert gas atmosphere of a high pressure, the gas-tightness is maintained completely despite of the high pressure and a single or plural baffle plate moving rods can be moved smoothly at the same speed.

It is a further object of the present invention to provide a baffle plate moving device capable of being mounted in a limited space efficiently without affecting at all the rotation of a single crystal pulling rod. The present invention, in order to obtain the above-mentioned objects, is characterised by the feature in the claims 1 and 2.

In the present invention in pulling a single crystal from a feed melt while allowing a baffle plate to float in a predetermined position below the surface of the feed melt, a plurality of moving rods for holding the baffle plate in the predetermined position are disposed in an opposed relation to each other with a single crystal pulling rod put therebetween or disposed radially around the pulling rod, and a drive means comprising magnets for moving the moving rods axially at the same speed is provided.

According to the present invention, moreover, in pulling up a single crystal in an inert gas atmosphere of a high pressure while allowing a baffle plate to float in a predetermined position below the surface of a feed melt, a cylinder of a hermetically sealed structure which encloses therein a moving rod for holding the baffle plate in the predetermined position is disposed on the side of a cylinder attached to a furnace and enclosing therein a single crystal pulling-up rod, the moving rod being moved up and down by a drive mechanism comprising magnets disposed inside and outside the moving rod enclosing cylinder.

Further, where plural moving rods are use, cylinders which enclose these moving rods therein are disposed in an opposed relation to each other with a single-crystal pulling rod enclosing tubular body put therebetween which tubular body is attached to the top of a furnace or are disposed radially around the pulling-up rod enclosing tubular body, and outside magnets of magnetic drive mechanisms for vertically moving the moving rods are rotated simultaneously by means of a gear mounted rotatably on the single crystal pulling up rod enclosing cylinder.

Under the construction described above, the baffle plate is stabilized by the provision of plural moving rods, and where the furnace interior is in an inert gas atmosphere of a high pressure, a single moving rod or plural moving rods can be moved smoothly while maintaining the high pressure furnace in a completely gas-tight condition and while preventing extra vibrations from being imparted to a single crystal pulling rod.

It was already known from DE—A—2306754 to displace and rotate a single-crystal pulling rod by a drive means comprising an outer electro-magnet cooperating with an inner ferromagnetic core affixed to the rod.

The above and other objects, features and advantages of the invention will become clear from the following description of preferred embodiments taken in conjunction with the accompanying drawings.

Fig. 1 is a schematic view illustrative of a first embodiment of the present invention;

Fig. 2 is a schematic view illustrative of a second embodiment of the invention;

Fig. 3 is a perspective view showing an example of a baffle plate as shown in Fig. 2;

Fig. 4 is a plan view of a top cover portion as shown in Fig. 2;

Fig. 5 is a sectional view taken on line A—A of Fig. 4; and Fig. 6 is a schematic view illustrative of a moving rod driving system as shown Fig. 2;

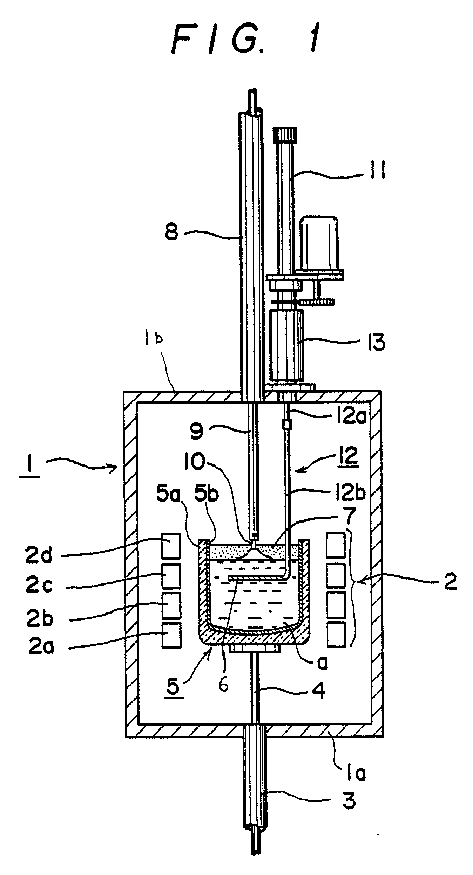

Referring first to Fig. 1, there is illustrated a first embodiment of the invention, the reference numeral 1 denotes a heat- and pressure-resistant electric furnace formed of, for example, stainless steel, and the numeral 2 denotes a heating means comprising, for example, axially quartered heaters 2a, 2b, 2c and 2d. From the central part of a bottom cover 1a of the electric furnace 1 is suspended gas-tightly a thin-walled lower tubular body 3 of a hermetically sealed structure having a small diameter, with a crucible supporting rod 4 being inserted through the lower tubular body 3 into the furnace 1. The crucible supporting rod 4 is vertically moved and rotated by magnetic drive means (not shown) disposed inside and outside the lower tubular body 3, and on its upper end is fixed a crucible 5 which comprises an outer crucible 5a formed of, for example, graphite and an inner crucible 5b formed of, for example, quartz. In the crucible 5 is contained a feed melt "a" which is, for example, GaAs, in which is floated a baffle plate 6 having an outside diameter somewhat smaller than the inside diameter of the crucible 5 and the upper surface of which is covered with a liquid sealing agent 7 such as, for example, $B_2O_3$.

On the central part of a top cover 1b of the electric furnace 1 is erected gas-tightly a thin-walled upper tubular body 8 of a hermetically sealed structure having a small diameter, and a single-crystal pulling rod 9 is suspended through the interior of the upper tubular body 8 and inserted in the furnace 1, with a seed crystal 10 being attached to the fore end of the rod 9. The single crystal pulling rod 9 is vertically moved and rotated by magnetic drive means (not shown) disposed inside and outside the upper tubular body 8. On the top cover 1b is erected a cylinder 11 in a position adjacent to the upper tubular body 8. Suspended through the cylinder 11 into the furnace 1 is a moving rod 12 which comprises a piston rod 12a formed of, for example, stainless steel and a pressing rod 12b formed of, for example, boron nitride (BN). The numeral 13 denotes an outside magnet as a constituent member of the magnetic drive mechanism as will be described later. To the fore end of the moving rod 12 is fixed the baffle plate 6 for preventing a heat convection in the feed melt "a", the baffle plate 6 occupying a predetermined position below the surface of the feed melt "a'.

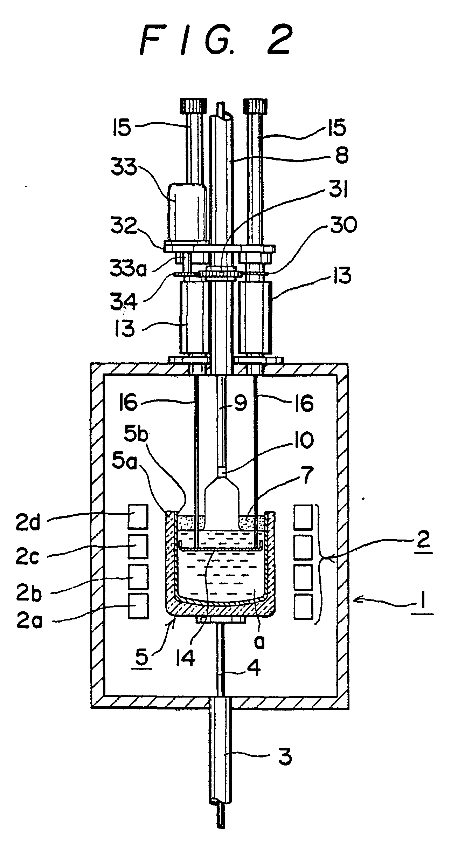

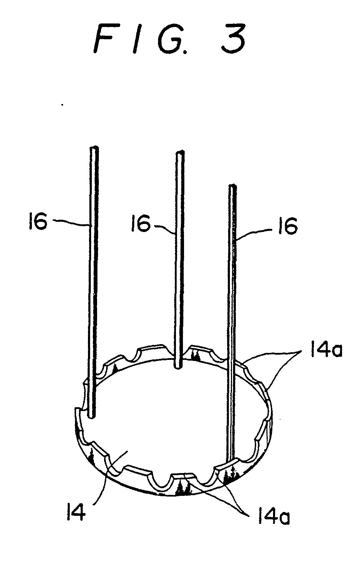

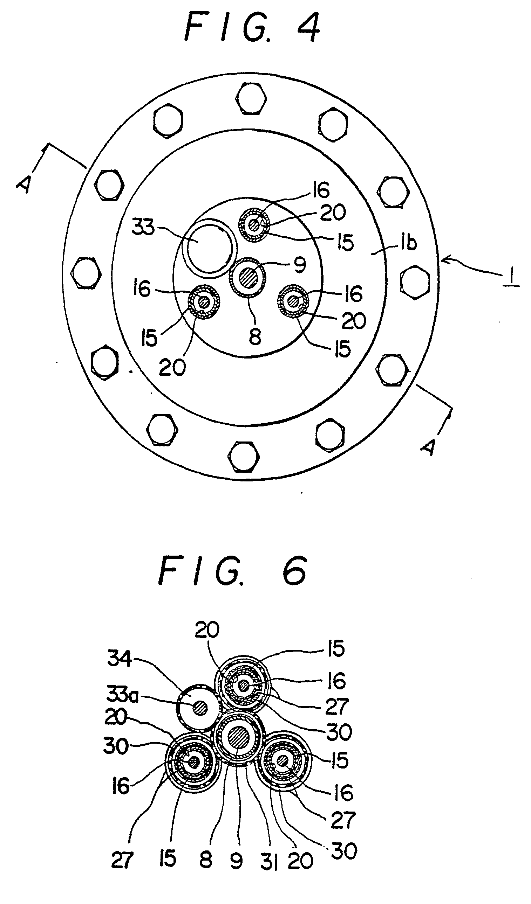

Referring now to Figs. 2 to 6, there is illustrated a second embodiment of the invention, in which the portions indicated by the same reference numerals as in the above embodiment represent the same members, so their explanation will be omitted. As shown, three cylinders 15 are erected at equal intervals and radially around an upper tubular body 8, and three moving rods 16 each comprising a piston rod 16a formed of stainless steel and a pressing rod 16b formed of BN, which rods are axially coupled together, are suspended through the cylinders 15 into the furnace 1, and their fore ends press a baffle plate 14 having an unevenness 14a on its circumference to hold it in a prderetermined position below the surface of the feed melt "a".

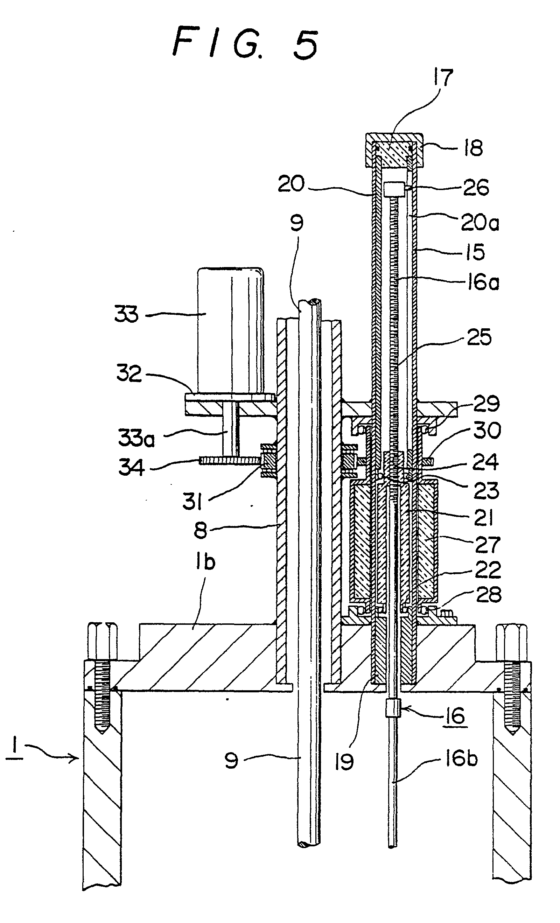

The internal structure of the cylinders 15 will now be explained with reference to Fig. 5. The cylinder 15 is hermetically sealed by a plug 17 fitted in the upper end and a cover 18 fitted threadedly over the upper end. In a lower inside portion of the cylinder 15 is inserted a holding cylinder 19, while from the plug 17 fitted in the upper portion is suspended a relatively long suspending cylinder 20 having an axially extending guide slot 20a. Between the holding cylinder 19 and the suspending cylinder 20 is mounted a cylindrical inside magnet 21 rotatably through, for example, bearing mechanisms 22 and 23. The inside magnet 21 has an internal thread portion 24, with which is engaged an external thread portion 25 formed on the piston rod 16a of the moving rod 16 extending through the inside magnet 21 and the suspending cylinder 20 and further through the holding cylinder 19. To the upper end of the piston rod 16a is attached a sliding key 26, which is engaged with the guide slot 20a formed in the suspending cylinder 20.

Further, outside the cylinder 15 and in a position opposed to the inside magnet 21 is disposed a cylindrical outside magnet 27 rotatably through, for example, ball bearing mechanisms 28 and 29, and a driven gear 30 adapted to rotate together with the outside magnet 27 is in mesh with a main driving gear 31 which is mounted rotatably on the outer periphery of the upper tubular body 8. Also in mesh with the main driving gear 31, as shown in Fig. 6, are driven gears 30 mounted on the outside magnets 27 disposed outside the other two cylinders 15 with the moving rods 16 enclosed therein, and the main driving gear 31 per se is in mesh with a driving gear 34 mounted on a driving shaft 33a of a drive motor 33 fixed to a base plate 32 which in turn is fixed to the upper tubular body 8.

In the above arrangement, for growing and pulling up a single crystal, first a portion of a polycrystal of GaAs is placed in crucible 5, then the baffle plate 14 is put thereon, further the remainder of the GaAs polycrystal is charged into the crucible 5, and a disc-like $B_2O_3$ is placed thereon. Then, the crucible 5 is put inside heating means, and the interior of a furnace 1 is vacuum-evacuated. Thereafter, an inert gas is introduced into the furnace 1 to pressurize the furnace interior to 100 atm, and heaters 2a, 2b and 2c and a heater 2d are raised in temperature to 1400°C and 1200°C, respectively. As a result, first $B_2O_3$ melts and covers the upper surface of the GaAs polycrystal. Then, the GaAs polycrystal melts and the baffle plate 14 floats on the upper surface of the feed melt "a" which is ascribable to its specific gravity and then covered with $B_2O_3$ as a liquid sealing agent 7. After observing this state through a peep glass (not shown) or after confirming the melting with a temperature measuring means (not shown), the drive motor 33 is rotated, whereby this rotating force is transmitted through the driving gear 34 to the main driving gear 31 and further to the driven gears 30, so that the outside magnets 27 start rotating at the same time and rotate the inside magnets 21. Consequently, the piston rods 16a of the moving rods 16 engaged with the internal thread portions 24 which rotate together with the inside magnets 21 move down at the same speed while being prevented from rotation by the sliding keys 26, thereby causing the three pressing rods 16b to be immersed into the crucible 5. The thus-immersed three pressing rods 16b reach the baffle plate 14 through the liquid sealing agent 7 of $B_2O_3$ and press it levelly into the feed melt "a", so that the baffle plate 14 is brought down to a predetermined position below the surface of the feed melt "a" without being inclined, whereupon the drive motor 33 is stopped to stop the baffle plate 14 in that predetermined position.

The descending distance is decided according to a preset program, and if the crucible 5 is rotated during the downward movment of the baffle plate 14, the descending motion will be effected more smoothly. After the baffle plate 14 is thoroughly contacted with the feed melt "a", a single crystal pulling-up operation is performed in a conventional manner by moving down a single crystal pulling rod 9 from above. As the melt level lowers with growth of the single crystal, the three moving rods 16 are also brought down simultaneously to maintain the spacing between the baffle plate 14 and the surface of the feed melt "a" at a constant spacing during the single crystal pulling-up operation.

Although plural moving rods 16 are used in the second embodiment, there may be used a single moving rod 12 as shown in the first embodiment where the crucible 5 is of a large capacity and a sufficiently strong baffle plate 6 and moving rod 12 can be used. Also in the case where the baffle plate 6 is of a small diameter, about the same as the diameter of the single crystal to be pulled, a single moving rod can be used. Even in this case, in a high pressure gas atmosphere of the furnace interior, the moving rod 12 can be moved smoothly without impairing the gas-tightness at all by means of the magnetic drive mechanism (as shown Fig. 5) disposed inside and outside the thin-walled cylinder 11 of a small diameter with the moving rod 12 enclosed therein.

In the second embodiment, moreover, since the rotating force of the single-crystal pulling rod 9 is not utilized as the drive source for the main driving gear 31 and the main driving shaft 31 is rotatably mounted on the upper tubular body 8 with the single-crystal pulling rod 9 enclosed therein, vibrations which prevent the growth of the crystal will never be transmitted to the rod 9. This driving force transmission means may be constructed so that pulleys mounted on the plural outside magnets 13 are rotated simultaneously through a single endless belt entrained thereabout.

According to the second embodiment, moreover, the three cylinders 15 each enclosing the moving rod 16 therein are disposed radially at equal intervals around the upper tubular body 8, and the driven gears 30 which rotate together with the outside magnets 27 disposed outside the three cylinders 15 are rotated simultaneously by means the main driving gear 31 mounted on the upper tubular body 8. Consequently, the baffle plate moving device can be mounted efficiently in a limited narrow space.

During the single crystal pulling operation, the spacing between the upper surface of the baffle plate 6 (14) and the surface of the feed melt "a" may be maintained at a constant spacing by holding the moving rod 12 or rods 16 in a predetermined position while moving the crucible 5. This is also included in the technical scope of the present invention since the moving rod 12 or rods 16 are once moved vertically.

**Claims**

1. An apparatus for pulling a single crystal from a feed melt (a) contained in an electric furnace (1) and being maintained in an inert gas atmosphere of a high pressure, comprising a single-crystal pulling rod (9), a baffle plate (6) in said feed melt (a), a baffle plate positioning and moving device having a vertical moving rod (12), engaging the baffle plate (6) to hold it in a predertermined position below the surface of the feed melt (a), and a drive means for vertically moving the moving rod (12), characterized in that the moving rod (12) is enclosed in an hermetically sealed cylinder mounted on an upper surface (1b) of the furnace (1), and that the drive means comprises an inner magnet (21) rotatably mounted inside the cylinder (11), an outer magnet (13, 27) rotatably mounted outside the cylinder (11), and a drive motor for driving the outer magnet, the moving rod being formed with an external thread portion (25), engaging an internal thread portion (24) of the inner magnet (21), and the moving rod (12, 16) being prevented from rotation by a sliding key mechanism (26).

2. An apparatus for pulling a single crystal from a feed melt (a) contained in an electrical furnace (1) and being maintained in an inert gas atmosphere of a high pressure, comprising a single-crystal pulling rod (9), a baffle plate (14) in said feed melt (a), a baffle plate positioning and moving device having a vertical moving rod (16) engaging the baffle plate (14) to hold it in a predetermined position below the surface of the feed melt (a), and a drive means for vertically moving the moving rod (16) characterized in that the baffle plate positioning and moving device comprises a plurality of vertical baffle plate moving rods (26), the pulling rod (9) being enclosed in an upper tubular body (8) mounted on an upper surface of the furnace (1), that each moving rod (16) is enclosed in an hermetically sealed cylinder (15) mounted on said upper furnace surface and disposed opposed to each other with the tubular body (8) therebetween or disposed radially around the tubular body (8), and that the drive means comprises for each cylinder an inner magnet (21) rotatably mounted inside the cylinder (15), an outer magnet (27) rotatably mounted outside the cylinder (15) and having a driven gear (30) mounted thereon, and a drive moter (33) for driving a driving gear (31) rotatably mounted on said tubular body (8) and engaged with each of said driven gears (30), each moving rod (16) being formed with an external thread portion (25) engaging an internal thread portion (24) of the associated inner magnet (21), and each moving rod (16) being prevented from rotation by a sliding key mechanism (26), the drive means moving the moving rods (16) axially at the same speed.

3. An apparatus as claimed in claims 1 or 2, wherein each moving rod (12) is fixed with its respective end to the baffle plate (6).

4. An apparatus as claimed in claim 2, wherein the moving rods (16) are merely in abutment with the upper surface of the baffle plate (14).

**Patentansprüche**

1. Vorrichtung zum Ziehen eines Einkristalls aus einer Zuführ-Schmelze (a), die in einem elektrischen Schmelzofen (1) enthalten ist und unter einer Inertgasatmosphäre von hohem Druck gehalten ist, mit einer Ziehstange (9) zum Ziehen eines Einkristalls, einer Stauplatte (6) in der ZuführSchmelze (a), einer die Stauplatte (6) positionierenden und bewegenden Vorrichtung, die eine vertikale Bewegungsstange (12) aufweist, die an der Stauplatte (6) so angreift, daß diese in einer vorbestimmten Position unter der Oberfläche der Zuführ-Schmelze (a) gehalten wird, und einer Antriebsvorrichtung zum Vertikalen Bewegen der Bewegungsstange (12), dadurch gekennzeichnet, daß die Bewegungsstange (12) eingeschlossen ist in einen hermetisch abgedichteten Zylinder, der auf der Oberseite (1b) des Schmelzofens (1) montiert ist, und daß die Antriebsvorrichtung einen inneren Magneten (21), der innerhalb des Zylinders (11) drehbar befestigt ist, einen äußeren Magneten (13, 27), der außerhalb des Zylinders (11) drehbar befestigt ist und einen Antriebsmotor zum Antreiben des äußeren Magneten aufweist wobei die Bewegungsstange mit einem Außengewindeabschnitt (25) versehen ist, der in einen Innengewindeabschnitt (24) des inneren Magneten (21) eingreift, und die Bewegungsstange (12, 16) gegen Drehung von einem Gleitzapfen-Mechanismus (26) gehalten wird.

2. Vorrichtung zum Ziehen eines Einkristalls aus einer Zuführ-Schmelze (a), die in einem Elektrischen Schmelzofen (1) enthalten ist und unter einer Inertgasatmosphäre von hohem Druck gehalten ist, mit einer Ziehstange (9) zum Ziehen eines Einkristalls, einer Stauplatte (14) in der ZuführSchmelze (a), einer die Stauplatte (14) positionierenden und bewegenden Vorrichtung, die eine vertikale Bewegungsstange (16) aufweist, die an der Stauplatte (14) so angreift, daß diese in einer vorbestimmten Position unter der Oberfläche der Zuführ-Schmelze (a) gehalten wird, und einer Antriebsvorrichtung zum vertikalen Bewegen der Bewegungsstange (16), dadurch gekennzeichnet, daß die Vorrichtung zum Positionieren und Bewegen der Stauplatte eine Mehrzahl von Bewegungsstangen (26) für die Stauplatte enthält, wobei die Ziehstange (9) in einen oberen Rohrkörper (8) eingeschlossen ist, der auf der Oberseite des Schmelzofens (1) montiert ist, daß jede Bewegungsstange (16) in einem hermetisch abgedichteten Zylinder (15) eingeschlossen ist, der auf der Oberseite des Schmelzofens befestigt ist, die Bewegungsstangen einander beidseitig des Rohrkörper (8) gegenüberstehend oder radial rings des Rohrkörpers (8) angeordnet sind, und daß die die Antriebsvorrichtung für jeden Zylinder einen inneren Magneten (21), der innerhalb des Zylinders (15) drehbar befestigt ist, einen äußeren Magneten (27), der außerhalb des Zylinders (15) drehbar befestigt ist und eine an ihm befestigtes angetriebenes Zahnrad (30) aufweist und einen Antriebsmotor (33) zum Antreiben des Antreibszahnrades (31) aufweist, das drehbar auf dem Rohrkörper (8) befestigt ist und in jedes der angetriebenen Zahnräder (30) eingreift, wobei jede Bewegungsstange (16) mit einem Äußerengewindeabschnitt (25) versehen ist, der in einen Innerengewindeabschnitt (24) des zugeordenten inneren Magneten (21) eingreift und jede Bewegungsstange (16) gegen Drehung von einem Gleitzapfen-Mechansismus (26) gehalten wird, wobei die Antriebsvorrichtung die Bewegungsstangen (16) axial mit derselben Geschwindigkeit bewegen.

3. Vorrichtung nach Anspruch 1 oder 2, bei welcher jede Bewegungsstange (12) mit ihrem betreffenden Ende an der Stauplatte (6) befestigt ist.

4. Vorrichtung nach Anspruch 2, bei welcher die Bewegungsstangen (16) an der Oberseite der Stauplatte (14) nur anstoßend gehalten sind.

**Revendications**

1. Appareil pour retirer un monocristal à partir d'un bain de fusion (a) disposée dans un four électrique (1) et maintenu sous atmosphère de gaz inerte et sous une pression élevée, comprenant une tige de retrait (9) de monocristal, une plaque chicane (6) disposée dans ledit bain de fusion (a), un dispositif de positionnement et de déplacement de la plaque chicane, qui comporte une tige de commande verticale (12) placée en contact avec la plaque chicane (6) de manière à maintenir celle-ci dans une position prédéterminée au-dessous de la surface du bain de fusion (a), ainsi que des moyens d'entraînement ou de commande pour déplacer verticalement ladite tige de commande (12), caractérisé en ce que la tige de commande (12) est enfermée dans un cylindre étanche monté sur la face supérieure (1b) du four (1) et en ce que les moyens d'entraînement comportent un aimant intérieur (21) monté à rotation dans un cylindre (11), un aimant extérieur (13, 27) monté à rotation à l'extérieur dudit cylindre (11) ainsi qu'un moteur d'entraînement pour entraîner l'aimant extérieur, la tige de commande étant pourvue d'une partie filetée externe (25) engagée dans une partie taraudée (24) de l'aimant intérieur (21), cependant que la tige de commande (12, 16) est immobilisée à rotation par un mécanisme à clavette coulissante (26).

2. Appareil pour retirer un monocristal à partir d'un bain de fusion (a) contenu dans un four électrique (1) et maintenu dans une atmosphère de gaz inerte sous haute pression, comportant une tige de retrait (9) de monocristal, une plaque chicane (14) disposée dans ledit bain de fusion (a), un dispositif de positionnement et de déplacement de ladite plaque chicane, qui comprend une tige de commande verticale (16) mise au contact de la plaque chicane (14) afin de la maintenir dans une position prédéterminée au-dessous de la surface du bain de fusion (a), ainsi que des moyens d'entraînement pour déplacer verticalement la tige de commande (16), caractérisé en ce que le dispositif de positionnement et de déplacement de la plaque chicane comporte une pluralité de tiges de commande (26) verticales pour le déplacement de ladite plaque chicane, ladite tige de retrait (9) étant entourée d'un corps tubulaire supérieur (8) monté sur la face supérieure du four (1), en ce que chaque tige de commande (16) est entourée d'un cylindre (15) hermétiquement fermé qui est monté sur ladite face supérieure du four, ces cylindres étant disposés l'un en face de l'autre, de part et d'autre du corps tubulaire (8), ou disposés radialement autour dudit corps tubulaire (8), et en ce que les moyens d'entraînement comprennent pour chacun desdits cylindres un aimant intérieur (21) monté à rotation à l'intérieur du cylindre (15), un aimant extérieur (27) monté à rotation à l'extérieur du cylindre (15) intéressé, ainsi qu'un pignon entraîné (30) monté sur le cylindre et un moteur d'entraînement (33) appelé à entrainer un pignon d'entraînement (31) monté à rotation sur ledit corps tubulaire (8) et coopérant avec des pignons entraînés (30) respectifs, chacune des tiges de commande (16) étant pourvue d'une partie filetée (25) qui coopère avec une partie taraudée (24) de l'aimant intérieur (21) associé et chaque tige de commande (16) étant empêchée de tourner par un mécanisme à clavette coulissante (26), l'agencement étant tel que les moyens d'entraînement déplacent lesdites tiges de commande (16) en direction axiale à une même vitesse.

3. Appareil selon la revendication 1 ou 2, dans lequel chaque tige de commande (12) est fixée par son extrémité sur la plaque chicane (6).

4. Appareil selon la revendication 2, dans lequel les tiges de commande (16) sont simplement mises en contact avec la surface supérieure de ladite plaque chicane (14).

# F I G.   1

# F I G. 2

# FIG. 3

# F I G. 4

# F I G. 6

4

# FIG. 5